(19) Europäisches Patentamt

European Patent Office

Office européen des brevets

(11) **EP 1 542 370 A1**

(12) **EUROPEAN PATENT APPLICATION**

(43) Date of publication:
**15.06.2005 Bulletin 2005/24**

(51) Int Cl.⁷: **H03M 13/41**

(21) Application number: **04257434.3**

(22) Date of filing: **30.11.2004**

| | |
|---|---|
| (84) Designated Contracting States: **AT BE BG CH CY CZ DE DK EE ES FI FR GB GR HU IE IS IT LI LU MC NL PL PT RO SE SI SK TR** Designated Extension States: **AL HR LT LV MK YU** | (72) Inventors: • **Parthasarathy, Sivagnanam** **Carlsbad, CA 92009 (US)** • **Risso, Alessandro** **San Diego, CA 92121 (US)** |
| (30) Priority: **02.12.2003 US 727063** | (74) Representative: **Style, Kelda Camilla Karen et al** **Page White & Farrer,** **54 Doughty Street** **London WC1N 2LS (GB)** |
| (71) Applicant: **STMicroelectronics, Inc.** **Carrollton Texas 75006-5039 (US)** | |

(54) **Method and system for branch label calculation in a Viterbi decoder**

(57) In a convolutional decoder, eight branch labels for branches in two trellis butterflies are calculated using a single output of an encoder. For a group of four consecutive states, $S_i$, $S_{i+1}$, $S_{i+2}$, and $S_{i+3}$, state $S_{i+3}$ is loaded into a convolutional encoder and the convolutional encoder input bit is set to 1. The output bits of the convolutional encoder are used as a branch label in a first trellis butterfly. A branch label in the second trellis butterfly is calculated with a formula in a branch label calculator using the convolutional encoder output bits as an input to the formula. The remaining branch labels are calculated from the convolutional encoder output and the branch label output from the branch label calculator. Selected bits of the branch labels are used to address a small branch metric register file.

Fig. 5

EP 1 542 370 A1

## Description

The present invention relates generally to a Viterbi decoder and a Viterbi decoding method used in a maximum likelihood decoding method of a convolutional code used in a digital data communication system.

The need for reliable data transfer is becoming more and more important in today's digital world. When transferring data bits over a channel, the Viterbi algorithm is widely used for reducing the effects of noise that may corrupt a data stream. The Viterbi algorithm belongs to a large class of error correcting codes known as convolution codes.

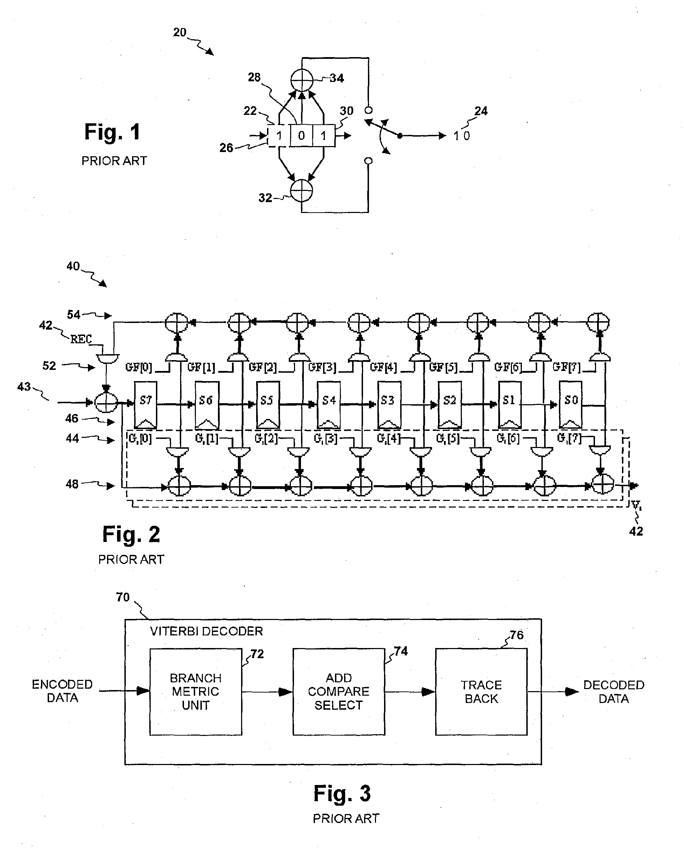

An example of a simple convolutional encoder **20** is depicted in **Fig. 1**. The rate of a convolution coder is defined as the ratio of the number of input bits to the number of output bits. Convolutional encoder **20** has a rate of 1/2 because the system encodes 1 input information bit **22** to produce 2 output encoded bits **24.** Convolutional encoder **20** has a shift register **26** for storing m-number of information bits **28** and **30**, and modulo-2 adders **32** and **34** that combine selected input bits to produce an output bit.

The number of bits that can be connected to a modulo-2 adder to influence the encoding of one output bit is called the "constraint length." In this document the constraint length is represented by the variable "K." Encoder **20** has a constraint length K = 3 because 3 bits- **22, 28,** and **30**-are used to compute output bits **24.** The selected connections between information bits **22, 28**, and **30** and modulo-2 adders **32** and **34** may be described by equations called "generator polynomials." A set of generator polynomials are represented herein as G [p:0] [K-1:0], where (p-1) -number of polynomials G are used, and each polynomial includes (K-2) bits (because it is assumed that the input bit is always connected to a modulo-2 adder). In the example of **Fig.** 1, there are 2 generator polynomials used; the first generator polynomial, which produces the first output bit (the output of modulo-2 adder **34**), is $G_0$ [1,1,1], and the second generator polynomial for the second output bit (the output of modulo-2 adder **32**) is $G_1$[1,0,1], where a 1 indicates a connection from a respective input bit memory location to a modulo-2 adder.

**Fig. 2** shows part of a more complex convolutional encoder **40** that can be selectively configured for various coding rates, and for non-recursive or recursive encoding. Encoder **40** encodes one output bit $V_i$ **42** for every input bit **43** according to generator polynomial $G_i$ [7:0] **44.** The generator polynomial **44** describes the connections between state bits S7 through S0 in shift register **46** and modulo-2 adders **48.** For a rate 1/N encoder, N-1 additional generator polynomials **44** and modulo-2 adder **48** circuits are added in parallel to produce N outputs, V[N-1:0], where each output bit is generated from input bit **43** and selected state bits S7 through S0 selected by one of p-1 generator polynomials G[p:0][K-2:0]. Note that p and N are not necessarily equal, and if N>p, then some generator polynomials **44** may be used more than once to produce more than one output bit **42**.

If convolutional encoder **40** is configured to operate in a recursive encoding mode, bit REC **50** is set to 1 and feedback polynomial GF[K-2:0] **52** is specified to determine connections between shift register **46** and modulo-2 adders **54**.

By selecting the proper generator polynomials, encoder **40** can be configured for constraint lengths K from 4 to 9 (i.e., 4 <= K <= 9). For example, for K=7, $G_i$ [7] and $G_i$[6] are set to 0 in each generator polynomial. In a preferred embodiment of encoder **40**, N sets of generator polynomials **44** and modulo-2 adders **48** may be used in parallel to produce various 1/N code rates, such as ½ to 1/6 (i.e., 2 <= N <= 6).

At the receiver of a digital data message, a Viterbi decoder may be used to decode the encoded stream of information bits by finding the maximum likelihood estimate of the transmitted sequence. Viterbi decoders are commonly used to decode the convolutional codes used in wireless applications. And other applications of forward error correcting codes and Viterbi decoders include CD and DVD players, high-definition TV, data-storage systems, satellite communications, and modem technologies.

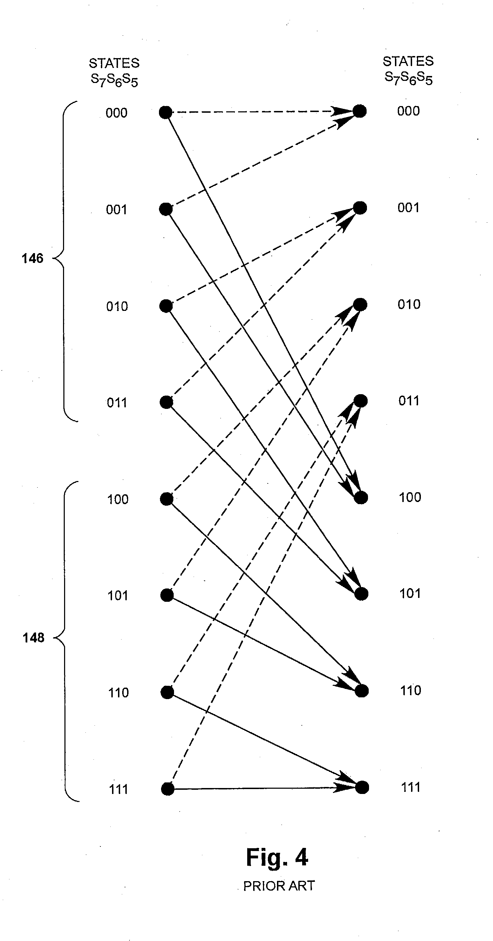

The trellis diagram depicted in **Fig. 4** is useful for diagramming the decoding process over time. It can be seen as a flow-control diagram where each node represents an encoder state, and the transitions from one state to another happen depending on the data input stream. Each of the $2^{K-1}$ nodes in a column of the trellis diagram denotes one of the potential $2^{K-1}$ encoder states. From any node a transition can be made-along a "branch" or "edge"-to one of two other nodes, depending upon whether a 0 or a 1 was received as an input data bit. Each branch has an associated "branch label" or "branch word" that is the output from the encoder that results from the transition of one encoder state to another in response to the 0 or 1 input bit.

The Viterbi algorithm is comprised of two routines-a metric update and a traceback. The metric update accumulates distances in code space for all states based on the current input symbol using the state transitions represented by the trellis diagram (similar to **Fig. 4**). The traceback routine reconstructs the original data once a path through the trellis is identified.

As shown in the block diagram of Viterbi decoder **70** in **Fig. 3**, branch metric unit **72** and add compare select (ACS) unit **74** perform the forward computational part of the Viterbi algorithm, while trace back unit **76** reconstructs the original data. The ACS operations are typically done by working on selected pairs of states that form a butterfly structure of the trellis. The operations consist of adding the previous path metrics to the respective branch metrics, and at each next state node selecting the best value (i.e., either a maximum or a minimum depending upon the convention of the metrics used) for the new path metrics and saving the decision bit that denotes which branch was chosen. A "branch metric" is the distance between the received sequence and the branch label. This distance is either hamming (for hard-decision decoding) or Euclidean (for soft-decision decoding). An accumulation of branch metrics forms the "state metric" or "path metric." The set of branch metrics for a stage in the trellis are derived from the received data usually at one time point. The Viterbi decoder will generate a branch metric value for each of the possible branches based on the input actually received by the decoder.

The problem of branch metric computation depends upon the generator polynomials and the state bits of the trellis butterfly for the current ACS operation. To find a branch label for one branch, the decoder hardware essentially implements the encoder function with the user supplied generator polynomials and a hypothetical input bit.

Therefore, it should be apparent that there is a need for an improved Viterbi decoder that efficiently calculates branch labels using fewer encoder cycles, less circuitry, and smaller silicon area.

In a convolutional decoder according to an embodiment of the invention, eight branch labels for branches in two trellis butterflies are calculated using a single output of an encoder. For a group of four consecutive states, $S_i$, $S_{i+1}$, $S_{i+2}$, and $S_{i+3}$, state $S_{i+3}$ is loaded into a convolutional encoder and the convolutional encoder input bit is set to 1. The output bits of the convolutional encoder are used as a branch label in a first trellis butterfly. A branch label in the second trellis butterfly is calculated with a formula in a branch label calculator using the convolutional encoder output bits as an input to the formula. The remaining branch labels are calculated from the convolutional encoder output and the branch label output from the branch label calculator. Selected bits of the branch labels are used to address a small branch metric register file.

For decoding a recursive code, a second formula is substituted for the formula used in a non-recursive system.

For a more complete understanding of the present invention, and the advantages thereof, reference is now made to the following descriptions taken in conjunction with the accompanying drawings, in which like numbers designate like parts, and in which:

Fig. 1 is a high-level schematic diagram of a prior art convolutional encoder;

Fig. 2 is a portion of a more complex prior art convolutional encoder that can be programmed to operate in various modes;

Fig. 3 is a high-level block diagram of a prior art Viterbi decoder;

Fig. 4 is a prior art trellis diagram;

Fig. 5 is a high-level block diagram of a portion of a convolutional decoder for calculating branch labels for two trellis butterflies in accordance with the method and system of the present invention;

Fig. 6 is a high-level block diagram of a portion of a convolutional decoder in accordance with the method and system of the present invention;

Fig. 7 is a block diagram of a logic circuit used for calculating a branch label in accordance with the method and system of the present invention; and

Fig. 8 is a high-level block diagram of a data receiver in accordance with the present invention.

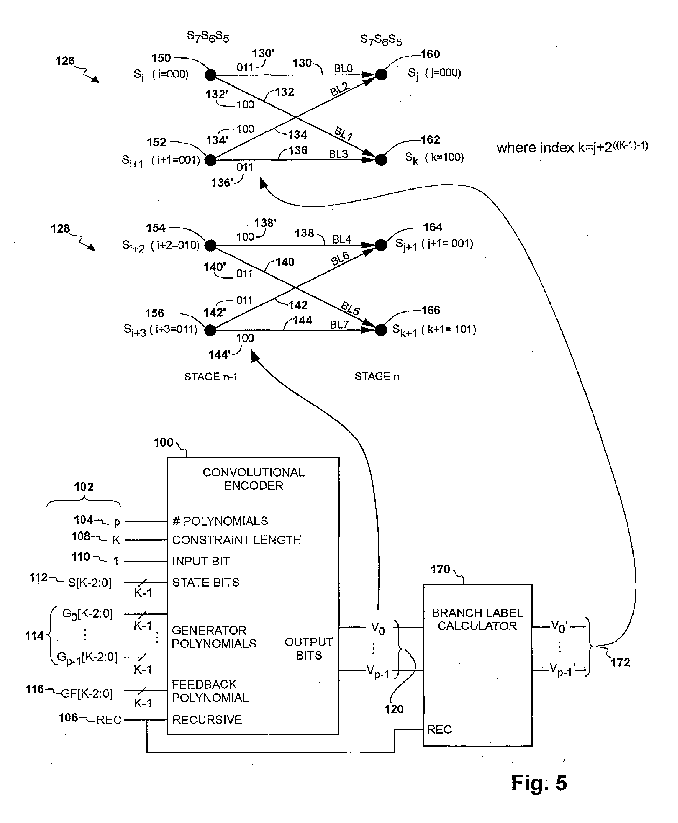

With reference now to the drawings, and in particular with reference to **Fig. 5**, there is depicted a high-level block diagram of a branch label calculator associated with branches in two trellis butterflies in accordance with the present invention. As shown, a configurable convolutional encoder **100** receives encoder parameters **102** to configure the encoder according to known encoding parameters used on the transmitter side of the data link. Parameters **102** may include, for example, number of generator polynomials p **104**, bit REC **106** to indicate whether or not recursive encoding is used, constraint length K **108**, input bit **110**, K-1 number of state bits **112**, p number of generator polynomials **114**, and feedback polynomial **116**. Encoder 100 may be implemented with encoder 40 shown in Fig. 2.

In a preferred embodiment, the number of polynomials p **104** may be limited to three distinct polynomials. Therefore, if the code rate is greater than 1/3, some generator polynomials are repeated so that a selected polynomial is used to produce more than one output bit **120**. The code rate is preferably from 1/2 to 1/6, inclusive. Constraint length K **108** is preferably from four to nine, inclusive. State bits **112** set the bits in the shift register, or memory locations, such as bits S0-S7 shown in shift register **46** in **Fig. 2**. In **Fig. 2**, S7 is the newest bit shifted into shift register memory **46**, and S0 is the oldest bit in shift register memory **46**. Generator polynomials **114** are of degree K-1 or less, and they specify the connections between the shift register **46** and the modulo-2 adder adders **48** (see **Fig. 2**). In **Fig. 2**, G [0] represents the presence or absence of a connection between S7, the newest bit in shift register memory **46**, and a modulo-2 adder, and G[7] represents the presence or absence of a connection between S0, the oldest bit in shift register memory **46**, and a modulo-2 adder.

In a Viterbi decoder, branch labels are calculated for every node in the decoding trellis at each unit of time. For each trellis butterfly, one label may be calculated and the remaining three labels may be easily derived.

**Fig. 5** shows how output bits $V_0...V_{p-1}$ **120** from convolutional encoder **100** represent a p-bit output branch word or branch label generated using the encoder state set by state bits **112** and the encoder mode set by parameters **102**. Two trellis butterflies **126** and **128** are shown at the top of **Fig. 5**. Trellis butterfly **126** includes branches or edges **130-136**, with corresponding branch labels **130'-136'**. Trellis butterfly **128** includes branches or edges **138-144**, with corresponding branch labels **138'-144'**. Branch labels **130'-144'** are also shown generically as **BL0-BL7**.

As shown by the arrow pointing to lower trellis butterfly **128**, output bits **120** may be used as branch label **144'** for branch **144.**

According to an important aspect of the present invention, branch labels are calculated for a selected group of four states in a trellis diagram. As shown in **Fig. 5,** states **150-156** are four consecutive states in a trellis. For example, 2 groups of four consecutive states are shown at group **146** and group **148** in **Fig. 4**. The "next state" indexes j and k for the two butterflies **126** and **128** are related by the formula:

$$k = j + 2^{((K-2)-1)}$$

The first state in the group of four, $S_i$ **150,** is preferably selected by a modulo-4 counter. In order to calculate branch label **144'** associated with the fourth state $S_{i+3}$ **156** in the group of four, convolutional encoder **100** is loaded with parameters **102,** including input bit **110** equal to 1, to produce output bits **120,** which are used as branch label **144'** (which is also **BL7**) for branch **144**. The remaining branch labels **138'** through **142'** in butterfly **128** may be calculated or derived from branch label **144'**. For example, branch label **138'** is the same as branch label **144'**, and branch labels **140'** and **142'** are the inverse of branch label **144'**.

To obtain branch labels **130'-136'** in trellis butterfly **126**, output bits **120** are used as inputs to branch label calculator **170**, which outputs bits **172** that are used as branch label **136'**. Once branch label **136'** is known, the remaining branch labels **130'-134'** of trellis butterfly **126** may be derived or calculated as follows: branch label **130'** is the same as branch label **136'** and branch labels **132'** and **134'** are the inverse of branch label **136'**.

Thus, using the symbols **BLO-BL7, BL3** is related to **BL7** by a function executed within branch label calculator **170**. The following equations show the relationships between the branch labels of two butterfly trellises **126** and **128**.

$$BL4 = BL7$$

$$BL5 = BL6 = \overline{BL7}$$

$$BL3 = f(BL7)$$

$$BL0 = BL3$$

$$BL1 = BL2 = \overline{BL3}$$

An important advantage of the present invention is that branch labels for two butterfly trellises may be calculated using one output cycle of one convolutional encoder. This is accomplished by using combinatorial logic within branch label calculator **170** to implement a formula for a bit-wise calculation of a branch label of a second butterfly using a branch label of a first butterfly. As shown in **Fig. 5**, the output of convolutional encoder **100** provides branch label **144'** for the first trellis butterfly **128,** while the output of branch label calculator **170** provides branch label **136'** for the second trellis butterfly **126.**

The inputs to branch label calculator **170** are output bits **122** from convolutional encoder **100** and bit REC **106**, which indicates whether or not convolutional encoder **100** is operating in a recursive or non-recursive mode. The outputs of branch label calculator **170** are output bits **172**, which are equivalent to the output of convolutional encoder **100** if it had been set to state **152** with a 1 applied at input bit **110**. These output bits may also be referred to as "the branch label for the input equals 1 transition from state $S_{i+1}$ to state $S_k$."

By calculating output bits **172** from bits **120,** the decoder can calculate 8 branch labels in a single cycle of one convolutional encoder **100**. In a typical Viterbi decoder application, a convolutional decoder **100** would be loaded with parameters **102** at least twice to produce two sets of output bits **120** in order to calculate branch labels for two butterfly trellises. By using branch label calculator **170**, the number of encoder cycles can be reduced by one-half, thereby saving the space needed to provide a second parallel convolutional encoder, or alternatively reducing the time needed for two encoding cycles to calculate the two branch labels.

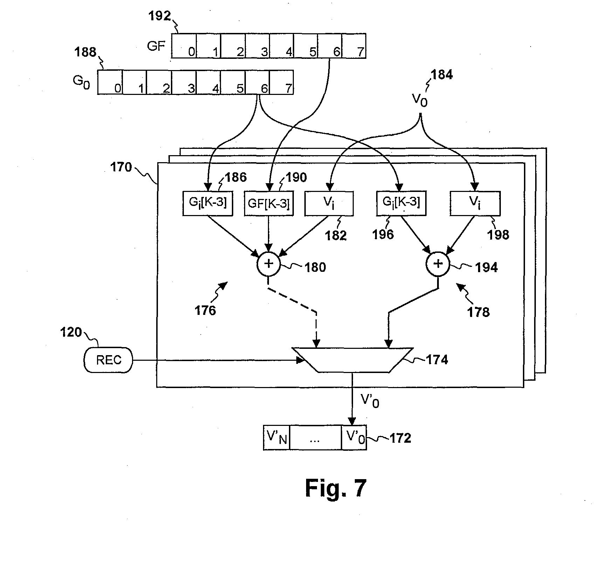

The formulas and high-level logic used to implement the formulas of branch label calculator **170** are shown in **Fig. 7**. As illustrated, output bits **172** are calculated by one of two formulas depending upon the state of REC bit **120**, which indicates whether or not the decoder is decoding a recursive or non-recursive convolutional code. If REC bit **120** is true, indicating the decoder is in the recursive mode, formula **176** on the left branch of the multiplexer **174** is used. This formula calculates one bit $V_i$ of output bits **172** by exclusive oring three input bits. One of the three input bits to exclusive or gate **180** is output bit $V_i$ **120** from convolutional encoder **100** (See **Fig. 5**) that corresponds to the selected one of the N-bits of V' being calculated. As an example, inputs for branch label calculator **170** are shown for cal-

culating bit $V'_0$. Therefore, input bit $V_i$ **182** is equal to $V_0$ **184**. Bit **186** is selected from generator polynomial $G_0$ **188**. Bit **186** is the (K-3)-bit of generator polynomial $G_0$ **188,** where, for this example, K=9 and the bits in generator polynomial $G_0$ are labeled in descending order from the right most bit of $G_0$.

Since the encoder is set in the recursive encoding mode, bit **190** is taken from feedback polynomial GF **192** from the (K-3) bit position, which for K=9 is the sixth bit of feedback polynomial GF **192**. When REC bit **120** is true, multiplexer **174** selects the output of exclusive or gate **180** and outputs $V'_i$, one of the bits in output bits **172**.

If REC bit **120** is false, the non-recursive mode is selected, and multiplexer **174** selects the output of exclusive or gate **194**, which executes the formula for calculating bit $V'_i$ for an encoder set to a non-recursive mode. Inputs to exclusive or gate **194** are the (K-3)-bit **196** of the ith generator polynomial **188**. In the example shown for calculating $V'_0$, generator polynomial **188** is $G_0$. And for K=9, the sixth bit is selected, wherein the bits in $G_0$ **188** are numbered from zero in ascending order from the left.

Similar to formula **176,** bit **198** is a selected bit $V_i$ **120** corresponding to the bit $V'_i$ being calculated. As shown in **Fig. 7**, output bits **172** are calculated in a bit-wise manner by inputting corresponding bit $V_i$ **120** and selecting the (K-3) bit from corresponding generator polynomials **188** and feedback polynomials **192**. This bit-wise calculation is indicated by several circuits **170** stacked in parallel, where one circuit calculates each output bit $V'_i$.

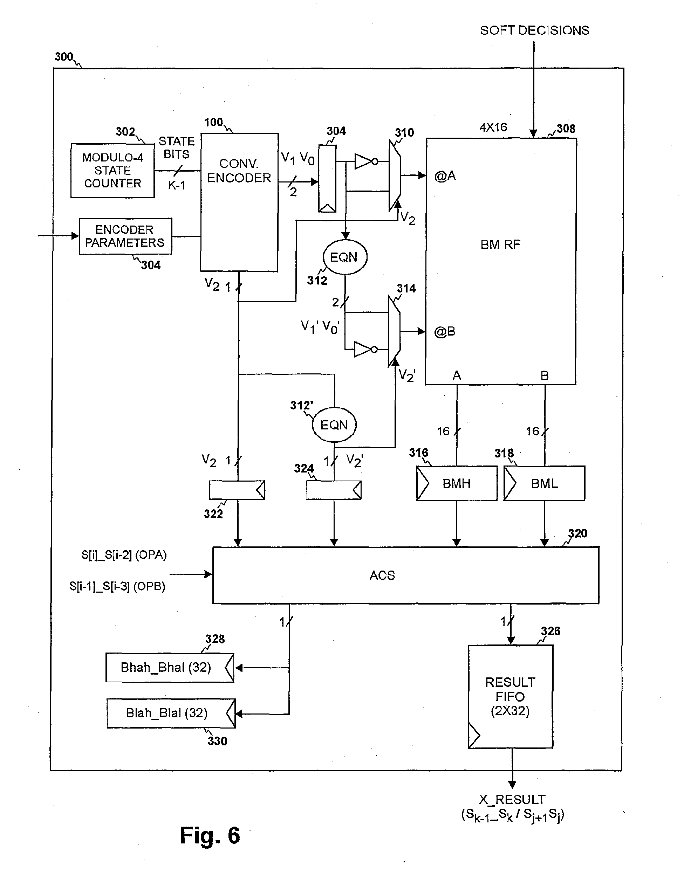

With reference now to **Fig. 6**, there is depicted a high-level block diagram of a portion of a co-processor for decoding a convolutional code using the Viterbi algorithm. As illustrated, co-processor **300** includes modulo-four state counter **302** that is used to select one state of the four consecutive states used to form two trellis butterflies. An example of the four selected states appears at group **146** in **Fig. 4** and at the top of **Fig. 5**, which shows states **150-156**. The output of modulo four state counter **302** is coupled to convolutional encoder **100**, which is similar to the convolutional encoder shown in **Fig. 5** and **Fig. 2**.

Convolutional encoder **100** also receives inputs from encoder parameters **304**. These encoder parameters are similar to encoder parameters **102** shown in Fig. 5. The encoder parameters may include: p, for specifying the number of polynomials; REC bit, for specifying whether or not the convolutional encoder operates in a recursive or non-recursive mode; constraint length K; an input bit; state bits; generator polynomials; and a feedback polynomial.

Convolutional encoder **100** outputs bits $V_0$-$V_2$, which represent the branch label or branch word for a particular branch or transition in the butterfly. Bits $V_0$-$V_1$, the least significant bits of the branch label, are stored in register **306**. The output of register **306** is used to provide a two-bit address for branch metric register file **308**. Register file **308** is a dual port memory that simultaneously receives two addresses shown as "@A" and "@B". Multiplexer **310** selects bits $V_1V_0$ or the inverse of $V_1V_0$, depending upon the state of $V_2$, which selects address @A as the output of multiplexer **310**.

Output bits $V_1V_0$ are also input into branch label calculator **312,** which is the same as branch label calculator **170** shown in **Fig. 7**. The outputs of branch label calculator **312** are bits $V_1'V_0'$, which are input into multiplexer **314,** along with the inverse of $V_1'V_0'$. The output of multiplexer **314** is provided to branch metric register file **308** as address "@B" depending upon the state of $V_2'$, which selects the output of multiplexer **314**.

Note that through addresses @A and @B, the lower two bits (least significant two bits) of $V_i$ and $V_i'$, and their inverses, supply all address bits needed to access the 4x16 register file **308**. Register file **308** is used to store information needed to recreate 8 branch metrics for all transitions in two trellis butterflies. The branch metrics are stored as combinations of four- or eight-bit soft decisions.

The output of register file **308** is provided at outputs A and B, which are each 16 bits wide and connected to registers BMH **316** and register BML **318**. BMH is the branch metric value stored at address @A and BML is the branch metric value stored at address @B. Registers **316** and **318** hold these branch metric values for use in calculations in add-compare-select unit **320**. Add compare select unit **320** also receives inputs $V_2$ and $V_2'$ from registers **322** and **324,** respectively. Note that $V_2'$ is calculated by branch label calculator **312',** which is the same as to branch label calculator **170** shown in **Figs. 5** and **7**.

Add-compare-select unit **320** adds or subtracts the branch metrics stored in registers BMH **316** and BML **318** to a previously calculated state metric to calculate first and second state metrics. The first and second state metrics are then compared, and the best state metric is saved for the next iteration of state or path metric calculations. The addition or subtraction of BMH **316** is controlled by the state of $V_2$ and the addition or subtraction of BML **318** is controlled by the state of $V_2'$. The output of add-compare-select unit **320** is stored in result FIFO **326**. Add-compare-select unit **320** stores additional data in registers **328** and **330**.

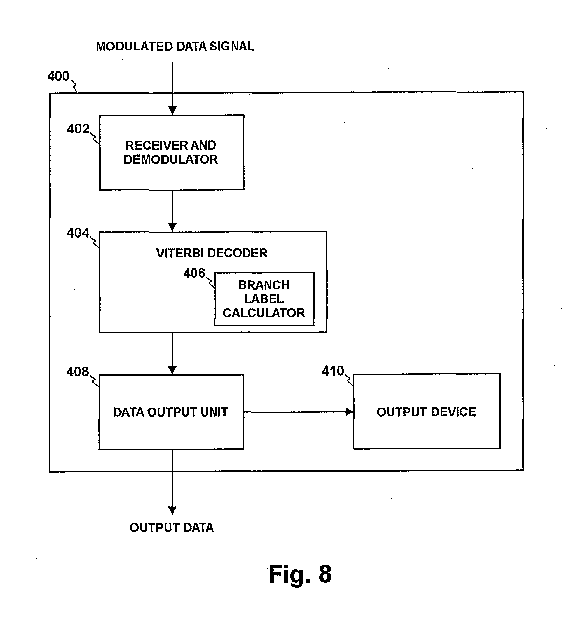

With reference now to **Fig. 8**, there is depicted a data receiver **400** in accordance with the method and system of the present invention. Data receiver **400** is used for receiving convolutionally encoded data transmitted in the form of a modulated data signal. Data receiver **400** may be implemented with a cell phone, a digital cable receiver, a satellite signal receiver, a wireless networking data receiver such as IEEE 802.11 compliant wireless Ethernet receiver, a cable modem, or the like.

As illustrated, data receiver includes receiver and a demodulator **402**, Viterbi decoder **404**, data output unit **408**, and optionally output device **410**. Receiver and demodulator **402** typically receives an analog signal and uses an A to D converter to produce a stream of data bits. Such data bits are encoded with a convolutional encoder similar to encoder **40** shown in **Fig. 2.** The data bits may be represented as hard or soft decisions.

Viterbi decoder **404** receives data from receiver and demodulator **402** and uses a Viterbi algorithm to decode the data stream. To produce a stream of information bits. In accordance with the present invention, Viterbi decoder **404** includes branch label calculator **406**, which may be implemented as shown in **Figs. 5, 6,** and **7**. Therefore, branch label calculator **406** can compute eight branch labels using a single cycle of a single convolutional encoder. Branch label calculator **406** provides increased Viterbi decoding performance by either reducing the number of circuits or encoders needed calculate eight branch labels using multiple encoders, or by reducing the number of encoder cycles needed to calculate eight branch labels using a single encoder.

Viterbi decoder **404** outputs information bits to data output unit **408**. Data output unit **408** formats the information bits or user data and provides the proper electrical and mechanical data interface. For example, data output unit **408** may provide a USB interface, an Ethernet interface, a fire wire interface, or other custom data bus interface.

Output device **410** may be used to provide a human data interface, such as a screen or an audio output. For example, if data receiver **400** is a cellular telephone, output device **410** may be implemented with a screen and an earpiece speaker to provide the user with both audio and video data.

The foregoing description of a preferred embodiment of the invention has been presented for the purpose of illustration and description. It is not intended to be exhaustive or to limit the invention to the precise form disclosed. Obvious modifications or variations are possible in light of the above teachings. The embodiment was chosen and described to provide the best illustration of the principles of the invention and its practical application, and to enable one of ordinary skill in the art to utilize the invention in various embodiments and with various modifications as are suited to the particular use contemplated. All such modifications and variations are within the scope of the invention as determined by the appended claims when interpreted in accordance with the breadth to which they are fairly, legally, and equitably entitled.

**Claims**

1. A method in a convolutional decoder for calculating branch labels comprising the steps of:

selecting a group of four consecutive states, $S_i$, $S_{i+1}$, $S_{i+2}$, and $S_{i+3}$, wherein $S_i$ and $S_{i+1}$ have next states $S_j$ and $S_k$ in a first trellis butterfly and $S_{i+2}$ and $S_{i+3}$ have next states $S_{j+1}$ and $S_{k+1}$ in a second trellis butterfly;

loading state $S_{i+3}$ into a convolutional encoder and setting the convolutional encoder input bit to 1, wherein the convolutional encoder parameters include a constraint length K and generator polynomials $G_p[K-2:0]$, wherein p is an index from 0 to p-1 for p-number of generator polynomials used to produce p-number of encoder output bits $[V_{p-1}:V_0]$ and bit G [0] represents a modulo-2 adder connection to the newest bit in an encoder shift register in the convolutional encoder; and

computing a first branch label $BL[V_{p-1} : V_0]$ for the input equals 1 transition from state $S_{i+1}$ to state $S_k$ in the first trellis butterfly using the formula

$$V_p = G_p[K-3] \text{ xor } V_p$$

where $G_p[K-3]$ is the K-3 bit of the $p^{th}$ generator polynomial and $V_p$ is the $p^{th}$ bit of the state $S_{i+3}$ encoder output bits $[V_{p-1}:V_0]$.

2. The method in a convolutional decoder according to claim 1 further comprising the steps of:

determining that the convolutional encoder is configured as a recursive convolutional encoder having a feedback polynomial GF [K-2:0];

in response to determining that the convolutional encoder is configured as a recursive convolutional encoder, computing the first branch label $BL[V_{p-1} :V_0]$ for the input equals 1 transition from state $S_{i+1}$ to state $S_k$ using the formula

$$V_p = G_p[K-3] \text{ xor } GF[K-3] \text{ xor } V_p$$

where $G_p[K-3]$ is the K-3 bit of the $p^{th}$ generator polynomial, $GF[K-3]$ is the K-3 bit of the feedback polynomial, and $V_p$ is the $p^{th}$ bit of the state $S_{i+3}$ encoder output bits $[V_{p-1} : V_0]$.

3. The method in a convolutional decoder according to claim 1 or claim 2 further comprising the steps of:

computing a branch label by setting a branch label for a transition from state $S_{i+3}$ to state $S_{k+1}$ equal to encoder output bits $[V_{p-1}:V_0]$ ;

computing a branch label by setting a branch label for a transition from state $S_{i+2}$ to state $S_{j+1}$ equal to the branch label for the transition from state $S_{i+3}$ to state $S_{k+1}$; and

computing branch labels by setting branch labels for transitions from state $S_{i+2}$ to state $S_{k+1}$ and from state $S_{i+3}$ to state $S_{j+1}$ equal to the inverse of the branch label for the transition from state $S_{i+3}$ to state $S_{k+1}$.

4. The method in a convolutional decoder according to any preceding claim further comprising the steps of:

computing a branch label by setting a branch label for a transition from state $S_i$ to state $S_j$ equal to $BL[V_{p-1} : V_0]$; and

computing branch labels by setting branch labels for transitions from state $S_i$ to state $S_k$ and from state $S_{i+1}$ to state $S_j$ equal to the inverse of $BL[V_{p-1} : V_0]$.

5. The method in a convolutional decoder according to any preceding claim further including the steps of:

addressing a branch metric register file using two least significant bits of a branch label for the input equals 1 transition from state $S_{i+1}$ to state $S_k$; and

addressing the branch metric register file using two least significant bits of a branch label for the input equals 1 transition from state $S_{i+3}$ to state $S_{k+1}$.

6. A branch metric unit for a Viterbi decoder comprising:

a state counter for selecting a group of four consecutive states, $S_i$, $S_{i+1}$, $S_{i+2}$, and $S_{i+3}$, wherein $S_i$ and $S_{i+1}$ have next states $S_j$ and $S_k$ in a first trellis butterfly and $S_{i+2}$ and $S_{i+3}$ have next states $S_{j+1}$ and $S_{k+1}$ in a second trellis butterfly;

a convolutional encoder loaded with state $S_{i+3}$ and having a convolutional encoder input bit equal to 1, wherein the convolutional encoder parameters include a constraint length K and generator polynomials $G_p[K-2:0]$, wherein p is an index from 0 to p-1 for p-number of generator polynomials used to produce p-number of encoder output bits $[V_{p-1}:V_0]$ and bit G[0] represents a modulo-2 adder connection to the newest bit in an encoder shift register in the convolutional encoder; and

a branch label calculator for computing a first branch label $BL[V_{p-1} : V_0]$ for the input equals 1 transition from state $S_{i+1}$ to state $S_k$ in the first trellis butterfly using the formula

$$V_p = G_p[K-3] \text{ xor } V_p$$

where $G_p[K-3]$ is the K-3 bit of the $p^{th}$ generator polynomial and $V_p$ is the $p^{th}$ bit of the state $S_{i+3}$ encoder output bits $[V_{p-1}:V_0]$.

7. The branch metric unit according to claim 6 further comprising:

a mode detector for determining that the convolutional encoder is configured as a recursive convolutional encoder having a feedback polynomial GF[K-2:0];

a branch label calculator responsive to the mode detector for computing the first branch label $BL[V_{p-1} : V_0]$ for the input equals 1 transition from state $S_{i+1}$ to state $S_k$, when the convolutional encoder is configured as a recursive convolutional encoder, using the formula

$$V_p = G_p[K-3] \text{ xor } GF[K-3] \text{ xor } V_p$$

where $G_p[K-3]$ is the K-3 bit of the $p^{th}$ generator polynomial, GF[K-3] is the K-3 bit of the feedback polynomial, and $V_p$ is the $p^{th}$ bit of the state $S_{i+3}$ encoder output bits $[V_{p-1}:V_0]$.

8. The method in a convolutional decoder or the branch metric unit according to any preceding claim wherein state indices j and k associated with states $S_j$ and $S_k$, respectively, are related by the formula

$$k = j + 2^{((K-2)-1)}.$$

9. A data receiver for receiving convolutionally encoded data comprising:

a receiver and demodulator for receiving user data;

a Viterbi decoder coupled to the receiver and demodulator, wherein the Viterbi decoder includes a branch metric calculator that includes:

a state counter for selecting a group of four consecutive states, $S_i$, $S_{i+1}$, $S_{i+2}$, and $S_{i+3}$, wherein $S_i$ and $S_{i+1}$ have next states $S_j$ and $S_k$ in a first trellis butterfly and $S_{i+2}$ and $S_{i+3}$ have next states $S_{j+1}$ and $S_{k+1}$ in a second

trellis butterfly;

a convolutional encoder loaded with state $S_{i+3}$ and having a convolutional encoder input bit equal to 1, wherein the convolutional encoder parameters include a constraint length K and generator polynomials $G_p$[K-2:0], wherein p is an index from 0 to p-1 for p-number of generator polynomials used to produce p-number of encoder output bits $[V_{p-1}: V_0]$ and bit G [0] represents a modulo-2 adder connection to the newest bit in an encoder shift register in the convolutional encoder; and

a branch label calculator for computing a first branch label $BL[V_{p-1} : V_0]$ for the input equals 1 transition from state $S_{i+1}$ to state $S_k$ in the first trellis butterfly using the formula

$$V_p = G_p[K-3] \text{ xor } V_p$$

where $G_p$[K-3] is the K-3 bit of the $p^{th}$ generator polynomial and $V_p$ is the $p^{th}$ bit of the state $S_{i+3}$ encoder output bits $[V_{p-1}:V_0]$; and
a data output unit coupled to the Viterbi decoder for formatting and outputting the user data.

**10.** The data receiver according to claim 9 wherein the branch metric calculator in the Viterbi decoder further includes:

a mode detector for determining that the convolutional encoder is configured as a recursive convolutional encoder having a feedback polynomial GF[K-2:0];

a branch label calculator responsive to the mode detector for computing the first branch label $BL[V_{p-1} :V_0]$ for the input equals 1 transition from state $S_{i+1}$ to state $S_k$, when the convolutional encoder is configured as a recursive convolutional encoder, using the formula

$$V_p = G_p[K-3] \text{ xor } GF [K-3] \text{ xor } V_p$$

where $G_p$[K-3] is the K-3 bit of the $p^{th}$ generator polynomial, GF[K-3] is the K-3 bit of the feedback polynomial, and $V_p$ is the $p^{th}$ bit of the state $S_{i+3}$ encoder output bits $[V_{p-1}:V_0]$.

**11.** The data receiver according to claim 9 or 10 further including an output device coupled to the data output unit for outputting an audible signal.

**12.** The data receiver according to any of claims 9 to 11 wherein the data receiver is a cellular telephone.

## Fig. 1
PRIOR ART

20

28  34

22  30

26  1  0  1

32

24  10

## Fig. 2
PRIOR ART

40

54

42  REC

52

43

46

44

48

GF[0]  GF[1]  GF[2]  GF[3]  GF[4]  GF[5]  GF[6]  GF[7]

S7  S6  S5  S4  S3  S2  S1  S0

$G_i[0]$  $G_i[1]$  $G_i[2]$  $G_i[3]$  $G_i[4]$  $G_i[5]$  $G_i[6]$  $G_i[7]$

$V_i$

42

## Fig. 3
PRIOR ART

70

VITERBI DECODER

ENCODED
DATA

72
BRANCH
METRIC
UNIT

74
ADD
COMPARE
SELECT

76
TRACE
BACK

DECODED
DATA

STATES
$S_7S_6S_5$

STATES
$S_7S_6S_5$

000     000

001     001

146

010     010

011     011

100     100

101     101

148

110     110

111     111

**Fig. 4**

PRIOR ART

Fig. 5

where index k=j+2$^{((K-1)-1)}$

SOFT DECISIONS

300

302 — MODULO-4 STATE COUNTER

STATE BITS

K-1

100 — CONV. ENCODER

ENCODER PARAMETERS — 304

$V_1$ $V_0$

304

2

310

$V_2$

312 — EQN

$V_2$ 1

4X16

308

BM RF

@A

2

314

$V_1'$ $V_0'$

$V_2'$

312' — EQN

@B

A

B

$V_2$ 1

322

324

1

$V_2'$

16

316 — BMH

16

318 — BML

S[i]_S[i-2] (OPA)

S[i-1]_S[i-3] (OPB)

320

ACS

1

1

326

328 — Bhah_Bhal (32)

330 — Blah_Blal (32)

RESULT FIFO (2X32)

X_RESULT
$(S_{k-1}\_S_k / S_{j+1}S_j)$

# Fig. 6

**Fig. 7**

MODULATED DATA SIGNAL

400

402 — RECEIVER AND DEMODULATOR

404 — VITERBI DECODER

406 — BRANCH LABEL CALCULATOR

408 — DATA OUTPUT UNIT

410 — OUTPUT DEVICE

OUTPUT DATA

**Fig. 8**

European Patent Office

**EUROPEAN SEARCH REPORT**

Application Number

EP 04 25 7434

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | ALLAN G ET AL: "A vlsi implementation of an adaptive-effort low-power viterbi decoder for wireless communications" ELECTRICAL AND COMPUTER ENGINEERING, 2001. CANADIAN CONFERENCE ON MAY 13-16, 2001, PISCATAWAY, NJ, USA,IEEE, vol. 2, 13 May 2001 (2001-05-13), pages 1183-1188, XP010551001 ISBN: 0-7803-6715-4 * page 1183, column 2, line 24 - page 1184, column 1, line 21; figure 2 * ----- | 1,6,9 | H03M13/41 |
| A | DAWID H ET AL: "Viterbi Decoders: High Performance Algorithms and Architectures" DIGITAL SIGNAL PROCESSING FOR MULTIMEDIA SYSTEMS, NEW YORK, NY : MARCEL DEKKER INC, US, 1999, pages 417-459, XP002225706 ISBN: 0-8247-1924-7 * page 428, line 1 - line 13 * ----- | 1,6,9 | |

TECHNICAL FIELDS SEARCHED (Int.Cl.7)

H03M

The present search report has been drawn up for all claims

| Place of search | Date of completion of the search | Examiner |
|---|---|---|
| The Hague | 22 April 2005 | Van Staveren, M |

EPO FORM 1503 03.82 (P04C01)